# EUROPEAN PATENT SPECIFICATION

(11) **EP 4 505 851 B1**
(45) Date of publication and mention of the grant of the patent: **03.09.2025**
(21) Application number: 23718360.3
(22) Date of filing: 04.04.2023
(51) Int. Cl.: H10N 60/10, H10N 60/12, G06N 10/40

(54) **TOPOLOGICAL SUPERCONDUCTING DEVICE**
TOPOLOGISCHE SUPRALEITENDE VORRICHTUNG
DISPOSITIF SUPRACONDUCTEUR TOPOLOGIQUE

(30) Priority: 05.04.2022 US 202263327403 P; 27.06.2022 US 202263355680 P
(43) Date of publication of application: 12.02.2025
(73) Proprietor: Yeda Research and Development Co. Ltd., 7610002 Rehovot (IL)
(72) Inventor: OREG, Yuval, 7630017 Rehovot (IL); LESSER, Omri, 7610002 Rehovot (IL); STERN, Adiel, 7610002 Rehovot (IL)
(74) Representative: Pearl Cohen Zedek Latzer Baratz UK LLP
(86) International application number: PCT/IL2023/050358
(87) International publication number: WO 2023/194998

(56) References cited:
- OMRI LESSER ET AL: "Majorana zero modes induced by superconducting phase bias", ARXIV.ORG, CORNELL UNIVERSITY LIBRARY, 201 OLIN LIBRARY CORNELL UNIVERSITY ITHACA, NY 14853, 13 December 2021 (2021-12-13), XP091121716
- ROMAN-PASCAL RIWAR ET AL: "Multi-terminal Josephson junctions as topological materials", ARXIV.ORG, CORNELL UNIVERSITY LIBRARY, 201 OLIN LIBRARY CORNELL UNIVERSITY ITHACA, NY 14853, 23 March 2015 (2015-03-23), XP081332978, DOI: 10.1038/NCOMMS11167
- OMRI LESSER ET AL: "One-dimensional topological superconductivity based entirely on phase control", ARXIV.ORG, CORNELL UNIVERSITY LIBRARY, 201 OLIN LIBRARY CORNELL UNIVERSITY ITHACA, NY 14853, 27 June 2022 (2022-06-27), XP091258555

## Description

### TECHNOLOGICAL FIELD

The presently disclosed subject matter relates to the field of topological superconducting devices which utilize unequal Fermi velocities and phase winding.

### BACKGROUND

Current proposals for topological qubits are based on combining two superconducting pads, a semiconductor with strong spin-orbit coupling that connects to the superconductor(s), and a magnetic field of the order of one Tesla. Progress in the realization of these proposals is hampered by the suppressing effect of the magnetic field on superconductivity, and by material limitations, in particular associated with the need to interface the superconductors and the semiconductor.

In the present invention the requirements imposed on the materials involved are significantly reduced, expressing them as easy-to-fulfill requirements on the electronic band-structure.

A goal/aim of the present invention is to provide a general prescription for inducing topological superconductivity. A key condition is that the material/s have unequal Fermi velocities for two spin branches of a device, with phase winding of the superconductors.

A further goal/aim of the invention is to provide a platform which is composed of a single material with no need for interfacing, thus paving a novel way to overcome the obstacles in the way of realizing a topological qubit.

Omri Lesser et al. in "Majorana zero modes induced by superconducting phase bias" (arXiV:2112.06766v1 [cond-mat.mes-hall] 13 Dec 2021) describe a planar SNSNS structure, the three superconducting regions exhibiting phase winding.

### SUMMARY

In one embodiment this invention provides a topological superconducting device comprising: three adjacent superconducting regions, comprising at least one material, disposed on a substrate, giving rise to two spin branches, wherein the three adjacent superconducting regions exhibit phase winding; and wherein one spin branch has a Fermi velocity that is not the same as the Fermi velocity of the second spin branch.

In one embodiment the topological superconducting device comprises at least one gate. In one embodiment a plurality of gates is used on superconducting regions (S) and/or non-superconducting regions (N). In one embodiment the gate can induce superconductivity. In one embodiment the topological superconducting device further comprises two non-superconducting regions disposed between three adjacent superconducting regions, arranged as two SNS junctions with one overlapping superconducting region forming an SNSNS junction.

In one embodiment, the three adjacent superconducting regions are arranged in parallel to one another and/or in a planar configuration. In one embodiment the substrate of the topological superconducting device is selected from a group comprising: a non-superconducting metal, a 2D electron gas material, a semiconductor, a dielectric medium, silicon, an oxide or combination thereof. In one embodiment two SNS junctions comprise at least one material wherein at least one gate is configured to modulate superconductivity in at least one material. In one embodiment of the topological superconducting device at least one gate is configured to modulate phase differences between three adjacent superconducting regions. In one embodiment three adjacent superconducting regions are gate-defined wires. In one embodiment the middle superconducting region of said three adjacent superconducting regions is wider than the width of the outer superconducting regions. In one embodiment at least one material is selected from a group comprising: a transition metal dichalcogenide (TMD), Al, Nb, Pb, NbSe₂, HgTe, InAs and InSb. In one embodiment of the topological superconducting device the TMD is selected from a group comprising: TaS₂, MoS₂, MoSe₂, MoTe₂, WS₂, WSe₂, WTe₂ or combination thereof. In one embodiment any of the materials can be doped.

In one embodiment the phase winding is 2π or occur at multiples of 2π. In one embodiment the topological superconducting further comprises a periodic modulation on top of, underneath and/or inside at least one of said three adjacent superconducting regions. In one embodiment the topological superconducting device further comprises at least one additional superconducting region parallel to said three adjacent superconducting regions. In one embodiment the topological superconducting device further comprises at least one additional non-superconducting region between at least one additional superconducting region parallel to three adjacent superconducting regions. In one embodiment the topological superconducting device further comprises additional layers in-between, next to, on top of and/or underneath said least three superconducting regions. In one embodiment at least one gate comprises a top-gate, back-gate, side-gate or combination thereof.

In one embodiment this invention provides a quantum computer comprising the topological device disclosed herein. In one embodiment the invention provides a topological superconducting array device comprising a plurality of the topological device disclosed herein. In one embodiment this invention provides a quantum computer comprising the topological array device.

### BRIEF DESCRIPTION OF THE DRAWINGS

In order to better understand the subject matter that is disclosed herein and to exemplify how it may be carried out in practice, embodiments will be described, by way of non-limiting examples only, with reference to the accompanying drawings, in which:
**Figure 1** is a schematic illustration of various embodiments of the relative widths of superconducting versus non-superconducting materials in an SNSNS junction.
**Figure 2A** is a schematic illustration of an SNSNS device setup with multiple gates.
**Figure 2B** is a schematic illustration of an SNS device setup that can be added on to existing SNSNS devices.
**Figure 2C** is a schematic illustration of an SNSNS device setup with a top layer containing a plurality of gates.
**Figure 3A** is a schematic illustration of a device depicting three superconducting regions, on a 2D electron gas with a periodic modulation on the middle superconducting region.
**Figure 3B** is a schematic illustration of a device depicting three separated superconducting regions, on a 2D electron gas with a periodic modulation on the middle superconducting region.
**Figure 3C** is a schematic illustration of a periodic modulation in an upper material.
**Figure 3D** is a schematic illustration of a periodic modulation at the interface between an upper and lower material.
**Figure 4A** is a schematic illustration of a phase-biased SNSNS junction.
**Figure 4B** is a graphical representation of a transverse spectrum of the SNSNS junction of **Figure 4A****,** using a model including next-nearest neighbor hopping.
**Figure 5** is a phase diagram for the SNSNS geometry of **Figure 4A**.
**Figure 6A** is a phase diagram for the SNSNS geometry of **Figure 4A****,** with extended regions of the phases *θ*, *ϕ*.
**Figure 6B** is the phase diagram as a function of the parameters *ϕ₁* = *ϕ+θ, ϕ₂ = ϕ-θ.*

For simplicity and clarity of illustration, elements shown in the figures are not necessarily drawn to scale, and the dimensions of some elements may be exaggerated relative to other elements. In addition, reference numerals may be repeated among the figures to indicate corresponding or analogous elements.

### DETAILED DESCRIPTION

In some embodiments the presently disclosed subject matter relates to inducing topological superconductivity in magnetic-field-free planar devices. In some embodiments two conditions are needed for this in a purely phase-controlled setup: superconducting phase winding and unequal Fermi velocities. In some embodiments phase winding is the time-reversal symmetry breaking mechanism. While it is true that any phase bias breaks time-reversal symmetry, the presently disclosed subject matter supports the separation of spin species that mimics the effect of the Zeeman field, when the phase winds. If the phase does not wind, the current flows back and forth between adjacent superconductors. The qualitative change that takes place when phase winding is introduced is the circulating current that flows around the system.

The role of unequal Fermi velocities is strongly linked to spin-orbit coupling. We note that a Fermi velocity imbalance does not occur when the electric field, responsible for the spin-orbit interaction, is purely out-of-plane. Additional factors, like in-plane electric fields which are common in transition metal dichalcogenides (TMDs) induce additional phases. In some embodiments, TMDs support unequal Fermi velocities in an SNSNS junction to induce a topological phase. In some embodiments, periodic modulations of at least one superconducting region are required to induce unequal Fermi velocities in an SNSNS junction.

As used herein, in reference to the structure of the device, "period modulation" refers to a physical and/or structural periodic modulation along, on top of, under and/or inside a region of the device e.g., on the surface of one of the superconducting (SC) regions and/or a coupling material, as detailed below.

The present invention provides a general prescription for inducing topological superconductivity in planar superconductor-normal-superconductor (SNS) Josephson junctions. In some embodiments Zeeman fields are not applied.

The invention relies on two key components:
- at least three parallel superconducting leads forming two SNS junctions (i.e., an SNSNS junction) with phase winding, and
- unequal Fermi velocities for the two spin branches transverse to the junction.

The term "Fermi velocity" herein denotes the velocity that corresponds to the Fermi energy of a particle.

The term "transverse" herein denotes a direction substantially perpendicular to a longitudinal axis. In particular, 'transverse' refers to the direction substantially perpendicular to parallel superconducting leads which form two SNS junctions.

The term "spin branches" herein refers to the spin states in the two separate SNS portions of an SNSNS device. In some embodiments, unequal Fermi velocities for the two spin branches in the direction transverse to the junction is required.

The term "superconducting" in the context of being a component of a device, herein denotes a surface, material or substrate which is in a superconducting state under suitable physical conditions, and which, when the device is in a functionally operational mode, is rendered superconducting by being put in the suitable physical conditions. In some embodiments the superconducting and/or gate-tunable material is termed the "functional" material.

The term "quantum proximity" herein denotes a close relative positioning of two structures, such that a physical property or state of one structure is capable of detectably affecting a quantum-mechanical property or state of the other structure.

In one embodiment, for two phase-differences between three superconductors, phase winding drives the system into a topological phase. The invention provides embodiments of physical platforms which exhibit unequal Fermi velocities. Two key points allow this objective to be exhibited. The first is the introduction of two phase differences by including three superconductors. With these two phase differences, phase winding drives the system into a topological phase. In one embodiment, the greater the difference between the Fermi velocities for the two branches, the larger the topological region.

The term "topological region" generally refers to a two-dimensional parameter plane wherein topological superconductivity occurs e.g., a phase space. A goal of the invention is to induce topological superconductivity within a device. Hence, numerous physical and material parameters, described throughout, can be fine-tuned to induce, optimize and increase the likelihood of topological superconductivity occurring within a device. Thus, a plurality of non-limiting materials, device layouts/geometries and architectures are exemplified herein as demonstrations of the invention.

As used herein "S" or "SC" can refer to the superconductor or superconductor/superconducting regions interchangeably. As will be described herein, in some embodiments a material can comprise physical and/or chemical properties which are inherently superconducting and in others superconductivity can be induced within a material e.g., by means of a gate-field or doping.

As used herein, the "normal" (N) region in an SNS and/or SNSNS junction, is considered any type of region that is not superconducting. Otherwise, as used herein, the term "normal" may be referred to interchangeably with the terms "trivial" or "insulating" inasmuch as the region does not display superconducting properties.

The term "phase winding" refers to a scenario wherein a phase of 2π creates a vortex which carries one unit of flux quantum. In general phase winding is a time-reversal symmetry breaking mechanism which assists in circulating current around the system. Phase winding can also occur at integers, or multiples of 2π i.e., 2πn where n is an integer greater than (but not including) zero. In some embodiments, utilizing phase winding together with unequal Fermi velocities can replace the need for an external Zeeman field.

In some embodiments, in the presence of spin-orbit coupling, the Fermi velocities are, in general, not equal, which forms a basis by which the present topological superconducting device operates. Herein "spin-orbit coupling" (SOC) generally refers to a relativistic interaction of a particle's spin with its motion inside a potential.

In some embodiments, the terms 'leads', 'electrodes', 'pads', 'regions', 'terminals' and 'substrates' are used interchangeably.

In some embodiments superconductivity in a material is induced by a gate potential, material doping or a combination thereof. In some embodiments a gate potential is applied directly (e.g., via leads) to the material and in other embodiments the gate potential is applied indirectly i.e., coupled to any number of other materials or layers such as oxides or other dielectric media. A dielectric medium refers to a medium which is an electrical insulator that can be polarized by an applied electric field.

As used herein "doping" or "chemical doping" refers to the introduction of an impurity (or impurities) with the purpose of modulating the materials' electrical, optical and/or structural properties.

In one embodiment more than one gate terminal interacts with any one of the SC regions. For example, an SC region can comprise an upper and/or a lower gate configuration such that the chemical potential is modulated in the SC region. In this embodiment, the gate potential defines the SC region which can define any shape and/or structure, as described below. Furthermore, the gate profile can be selected such that it optimizes the properties of the device. In some embodiments the gate biasing can be positive and in others it can be negative, and/or can vary from region to region of the device.

### Topological Superconducting Devices of the Invention

In some embodiments an SNSNS junction is comprised of one single material. In other embodiments, the S regions are comprised of different S materials. In one embodiment, gate-controlled superconductivity and unequal Fermi velocities in a single material (e.g., transition metal dichalcogenides) would not need quantum proximity coupling to an external superconductor and/or semiconductor. In some embodiments an SNSNS junction comprises more than one material.

In some embodiments, the geometric structure of the SNSNS junction, as embodied in a device, is primarily a planar junction but is not limited to this. The working principle of the invention is not limited to one particular device configuration, structure and orientation, as will be further detailed below. Furthermore, as will become clear, a plurality of the topological devices disclosed herein can be coupled together forming arrays of devices operating collectively. A 2D array of topological devices comprises a plurality of topological devices. In some embodiments the array comprises at least two topological devices. In some embodiments the array comprises between 2 and 10 topological devices. In some embodiments the array comprises between 2 and 100 topological devices. In some embodiments the array comprises between 100 and 1000 topological devices. In some embodiments the array comprises between 1000 and 5000 topological devices. In some embodiments the array comprises between 5000 and 10,000 topological devices. In some embodiments the array comprises between 10,000 to 1,000,000 topological devices. In some embodiments the array comprises between 1,000,000 and 1,000,000,000 topological devices. In some embodiments the array comprises between 1,000,000,000 and 1,000,000,000,000 topological devices.

Topological devices can be connected in arrays in any non-limiting manner, as known in the art. In some embodiments this is referred to as "topological superconducting array device", "array device" or simply an "array". The array device comprises a plurality of topological devices. In some embodiments, connecting topological devices is facilitated by any of the following non-limiting examples of materials, connection means and classes of materials: electrical connections, optical connections, connection by semiconductors, magnetic materials, alloys, magnetic semiconductors, magnetic insulators, superconductors, quantum materials and topological insulators. In some embodiments magnetic semiconductors are selected from: diluted magnetic semiconductors (DMS), yttrium iron garnet (YIG), bismuth iron garnet (BIG), magnetic oxides, half-metallic ferromagnets and magnetic topological insulators. Non-limiting examples of magnetic insulators includes ferrites, ceramic-based materials, rare-earth compounds, antiferromagnets, spin glasses and multiferroics. In some embodiments, the connection of topological devices is facilitated by any of the following: EuS, EuO, GdS:Eu, CoFe₂O₄, Cr₂Ge₂Te, including any compounds related to these families of materials. Further non-limiting examples of materials used for connecting topological devices of the present application include: rare earth metal chalcogenides, spinel ferrites, ceramic-based materials and TMDs.

Non-limiting examples of DMS materials are those doped with Mn, Fe or Co, for example (Ga,Mn)As, (In,Mn)As and (Zn,Mn)Te. Non-limiting examples of magnetic oxides include Fe₃O₄, CoFe₂O₄ and NiO. Non-limiting examples of magnetic topological insulators include Cr-doped (Bi,Sb)₂Te₃ and (Bi,Sb)₂Se₃.

Such devices and arrays can form components in devices such as the following non-limiting examples: electronic devices, integrated circuits, processors, quantum processors, quantum computers, quantum cryptography systems, quantum sensors and quantum communication systems. As used herein a "quantum computer" is a type of computer that uses qubits. A "qubit" being a unit of quantum information.

Reference will now be made to various figures which depict specific embodiments of the present invention. Those skilled in the art to which this invention pertains will readily appreciate that numerous changes, variations, and modifications can be made without departing from the scope of the presently disclosed subject matter, *mutatis mutandis.*

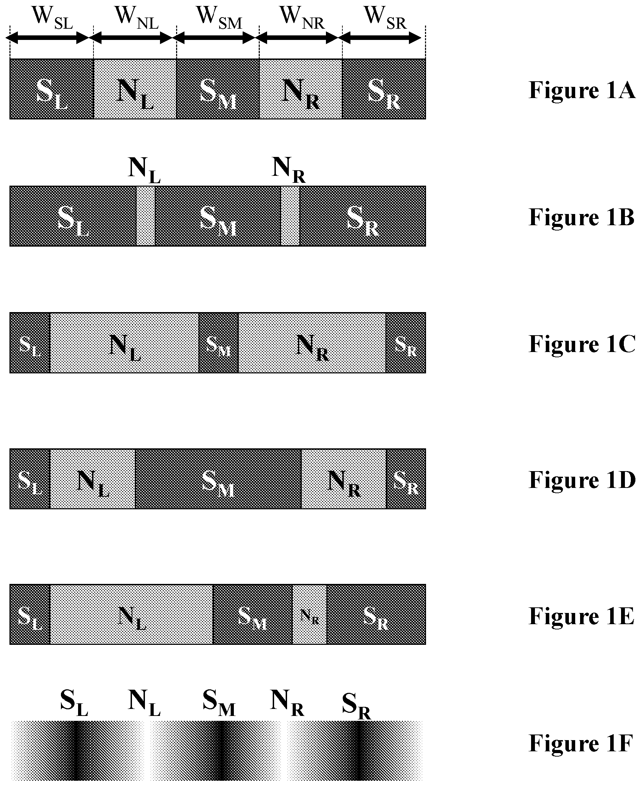

**Figure 1** illustrates a cross-section schema of different embodiments of an SNSNS junction and is labelled S_{L}N_{L}S_{M}N_{R}S_{R} wherein the subscript "L" corresponds to the 'left' side, the subscript "M" corresponds to the 'middle' and the subscript "R" corresponds to the 'right' side of the junction. In some embodiments, to describe the junction, the terms 'section', 'region' and 'side' are used interchangeably. In some embodiments the SNSNS junction is a planar device with parallel S and N regions or strips. Furthermore, the width of each S and N region of the S_{L}N_{L}S_{M}N_{R}S_{R} junction is denoted as "W" for convenience (see **Figure 1A**). For example, W_{SL} refers to the width of the left S region. In some embodiments all S and N regions are the same width, i.e., W_{S} = W_{N}, as shown in **Figure 1A**. **Figure 1A** is labelled with this convention (S_{L}, W_{SL}, N_{L}, W_{NL}, etc.) and the S and N region labelling analogously applies to **Figures 1B** **- 1F** as well. In some embodiments the width of each region in an SNSNS junction can be described by any one of the following scenarios:
- W_{S} ≠ W_{N} (as shown in **Figures 1B - 1E****)**
- W_{S} > W_{N} (as shown in **Figure 1B**); or
- W_{S} < W_{N} (as shown in **Figure 1C**); or
- W_{SL} = W_{SR} and W_{SM} > W_{SL/SR/NL/NR} (as shown in **Figure 1D**); or
- W_{SL} ≠ W_{NL} ≠ W_{SM} ≠ W_{NR} ≠ W_{SR} (one example is shown in **Figure 1E**).

In some embodiments the boundary and/or interface between S and N regions are well defined, which is depicted as separating S and N regions by a line (for example see **Figures 1A** - **1E**). In other embodiments the S and N regions, and the boundary/interfaces thereof, are not clearly defined (for example see **Figure 1F**). In one sense **Figures 1A - 1E** illustrate idealized configurations of SNSNS junctions, which does not detract from the essence of the invention, even though in 'real world' scenarios interfaces between materials (or one or more materials with regions of differing electronic states) may be less idealized. In some embodiments, the boundary and/or interface between S and N regions are continuous. In other embodiments the boundary and/or interface between S and N regions are discontinuous. In some embodiments S and N regions blur into one another and/or are continuous (see **Figure 1F**). The term "boundary" generally refers to a line that defines where one region begins and the other ends. The term "interface" generally refers to a region where two different systems, materials and/or items interact with one another.

In some embodiments the three superconducting regions are adjacent to one another. As used herein, "adjacent" can refer to regions that are touching, next to, near or in proximity of each other, even if they may be fully or partially separated.

In some embodiments, any of the layers and/or regions in a device form a structure as a component in a device as any one of the following: a monolayer, surface, thin film, layer and/or 3D shape/structure. In some embodiments, the structures of the device are fabricated by any one of the following: photolithography, electron-beam-lithography processes, physical vapor deposition, chemical vapor deposition, epitaxy, focused ion-beam, self-assembly, nanoimprinting, dry/wet etching, electrically induced nanopatterning, dry/wet deposition and/or a combination thereof.

In one embodiment the thickness of the SC and N layers in the device range from between 1 nanometer and 1000 nanometers. In one embodiment the thickness of the SC and N layers in the device range from between 1 nanometer and 200 nanometers. In one embodiment the thickness of the SC and N layers in the device range from between 1 nanometer and 500 nanometers. In one embodiment the thickness of the SC and N layers in the device range from between 500 nanometer and 1000 nanometers. In another embodiment the thickness of the SC and N layers in the device range from between 1 micron and 20 microns. In another embodiment the thickness of the SC and N layers in the device range from between 1 micron and 50 microns. In another embodiment the thickness of the SC and N layers in the device range from between 50 micron and 100 microns.

In another embodiment, the different S and/or N structures within the SNSNS device are of the same thickness and in other embodiments the thickness of different S and/or N structures are not the same. In another embodiment, the different SC and/or N structures within the SNSNS device are of the same and in other embodiments the shape of the different SC and/or N structures are not the same.

In some embodiments, the gate potential tunes a materials' electrical properties from insulating to superconducting e.g., in Al substrates. In some embodiments any material that has spin-orbit coupling can be used at the functional material. In some embodiments, quantum proximity of the SC region with the substrate is required. In some embodiments, phase-tuning of a superconducting state is realized by gates within the SNSNS device. In some embodiments, a single material can be used wherein a plurality of gates are used to induce superconductivity in specific regions, such as to form an SNSNS device within one material. In such an embodiment, there is no need for coupling to a 2D electron gas (2DEG) substrate.

In some embodiments a combination of intrinsic gate-controlled superconductivity and unequal Fermi velocities in layers of TMDs exhibits topological superconductivity in a single material system, without the need for quantum proximity coupling to an external superconductor.

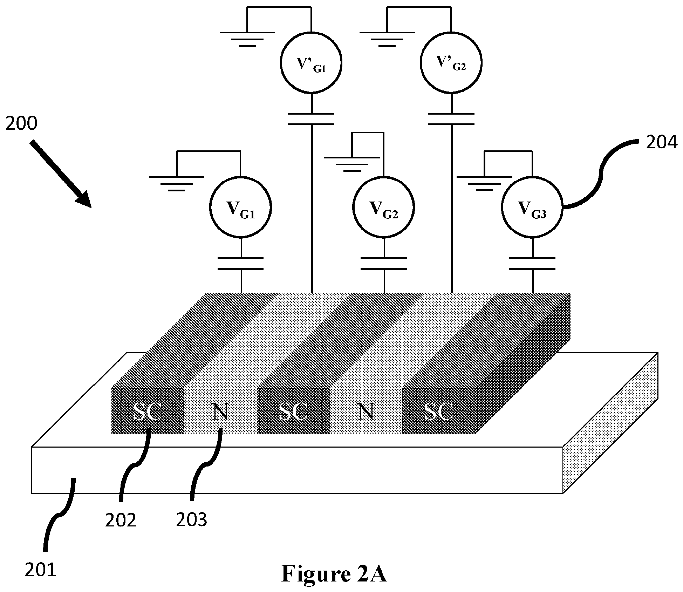

As illustrated in the schematic of **Figure 2A****,** the device **200** comprises SC regions **202** separated by N regions **203,** disposed on a substrate **201** and at least one gate **204,** three of which are depicted on the SC regions labelled V_{G1}, V_{G2} and V_{G3}, and two are depicted on the N regions labelled as V'_{G1}, V'_{G2}, shown as top-gates. For the purpose of clarity not all coupling layers and structures are shown in **Figure 2A****.** The at least one gate **204,** or plurality of gates, are shown as being connected to the SC and/or regions **202** via capacitors. In some embodiments, any number of gates can be used. In some embodiments, any number of additional layers (not shown), e.g., dielectric materials, are coupled to a plurality of electrodes to facilitate gating to any of the SC regions **202** and/or N regions **203.** In some embodiments the dielectric material is selected from: silicon, silicon oxide, silicon nitride, aluminum oxide, hafnium oxide, zirconium oxide, titanium dioxide, superconducting layer, semiconductor, topological insulating layer and polymers or any combinations thereof. In some embodiments, additional layers comprise at least one metal. In some embodiments, additional layers comprise graphene. These additional layers may be applied to any of the devices disclosed herein. In some embodiments additional layers comprise any of the following selected from: transition metal oxides, topological insulators, heavy fermion materials, semiconductors and organic molecules or any combinations thereof. The device **200** comprises at least three superconducting (SC) regions **202** made of a superconducting material and being in a superconducting state. In some embodiments, the SC and/or N regions can be adjacent regions, parallel strips or pads. A non-superconducting region (N) **203** separates each SC region **202** forming two connected SNS junctions, namely an SNSNS junction or device, disposed upon a substrate **201.** In one embodiment the SC regions **202** and N regions **203,** i.e., SNSNS junction, are disposed on a non-superconducting substrate **201.** According to some examples, the substrate **201** may comprise any one of, but not limited to, a non-superconducting metal, a semiconductor, a dielectric medium, an oxide and/or a combination thereof. In some embodiments the terms "topological device", "device" and "junction" are used interchangeably. The gates **204** are shown schematically as top-gates indirectly connected to the SC regions **202** and N regions **203,** although, as will become apparent below, the implementation of a gate-field is not limited to one particular set up. The gate-potential of any one of the gates used can be the same or different. In some embodiments, each gate **204** can provide a fixed (DC) or oscillating (AC) voltage. Said voltage can be applied directly to the corresponding region or indirectly via subsequent layers and/or electrodes e.g., a plurality of electrodes, appropriately placed and coupled. In some embodiments, the applied voltage profile is non-linear, pulsed, periodic and/or non-periodic. In some embodiments any one of the gates **204** can control the gate potential in one or more of the SC regions **202** and/or N regions **203.**

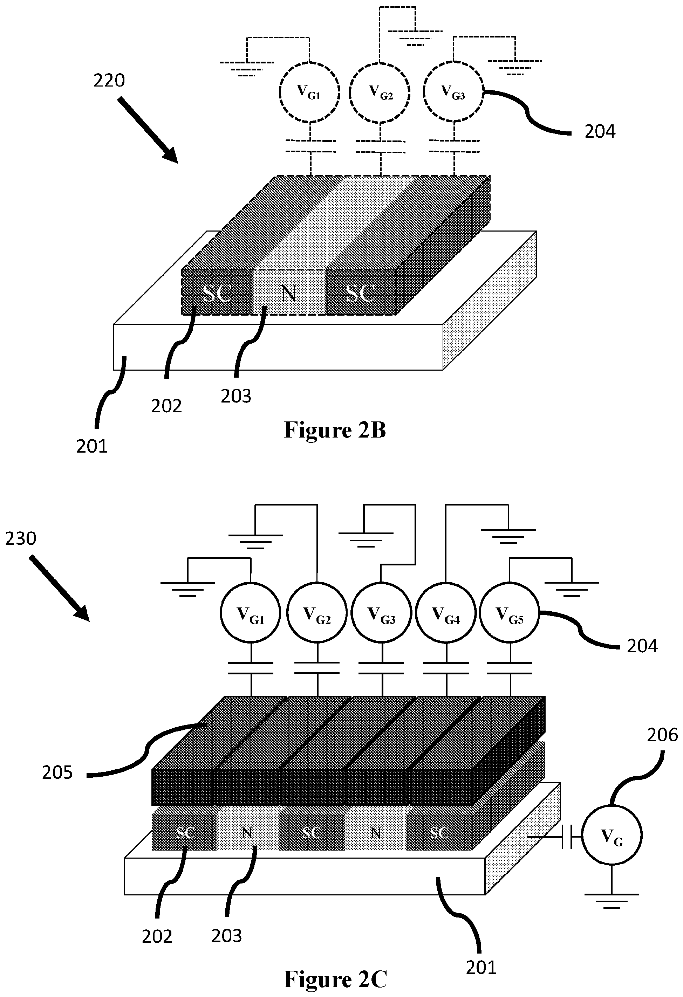

As illustrated in **Figure 2B****,** additional SNS junctions **220** comprising SC regions **202** separated by N regions **203,** disposed on a substrate **201,** can be added to existing SNS or SNSNS junctions, in parallel. For the purpose of clarity not all coupling layers and structures are shown in **Figure 2B****.** Accordingly, each SC and/or N region can comprise its own corresponding gate **204.** In some embodiments, each gate **204,** or plurality of gates, is connected to the SC regions **202** and/or N regions **203** via capacitors. In some embodiments, any number of layers of dielectric materials are coupled to a plurality of electrodes to facilitate gating to any of the SC regions **202** and/or N regions **203.** Furthermore, each SNSNS device can further comprise at least one additional SC region **202** and/or at least one additional N region **203.** Therefore a plurality of the topological devices disclosed herein can be coupled together forming arrays of devices operating collectively. In one embodiment a plurality of topological devices are coupled together forming an array of topological devices. In principle the connecting of a plurality of devices is extended to any of the devices disclosed herein.

As illustrated in **Figure 2C** a device architecture **230** comprises an SNSNS junction with SC regions **202** separated by N regions **203** disposed on top of a substrate **201.** For the purpose of clarity not all coupling layers and structures are shown in **Figure 2C****.** The SC regions **202** and N regions **203** are defined by a plurality of top-gate electrodes **204,** disposed in a top layer **205,** shown as strips, and additionally wherein the substrate **201** is back-gated **206.** The top gates **204** and bottom gates **206** tune the gate potential across the central layer which comprises the SNSNS junction, modulating the electronic properties in the SC regions **202** and N regions **203.** The electronic properties of the SNSNS layer can thus be controlled by gates. A plurality of such a device can be connected to form an array of devices operating collectively.

In some embodiments of the devices presented herein, the height, width, thickness and/or shape, of any of the SC and/or N and/or insulating regions can vary across the device. Furthermore, the devices presented schematically in the figures can incorporate additional layers in-between, next to, on top of and underneath any of the depicted layers to facilitate electronic coupling, or insulating of various parts of the device, as required by the device architecture, to achieve the stated aims of the present invention.

In some embodiments, the functional material used in the device may be made from any suitable superconducting material. In some embodiments, the superconducting material comprises: type I superconductors, type II superconductors, organic superconductors, iron-based superconductors and rare-earth metal based superconductors or any combination thereof. Non-limiting examples include Al, Nb, Pb, NbSe₂, HgTe, InAs, InSb and transition metal dichalcogenides (TMD). All of the substrates and/or electrodes, may be made from the same material, or two or more may be made from different materials. The functional and/or non-functional elements of a device can include TMDs, of which non-limiting examples include: MX₂ (M = Mo, W; X = S, Se, Te) MoS₂, MoSe₂, MoTe₂, WS₂, WSe₂, TaS₂, or WTe₂ or combination thereof. Indeed, any material that supports Fermi velocity imbalance can be used as the functional material for carrying out the invention. TMDs support Fermi velocity imbalance, which provides a platform to fulfil one of the conditions of the present invention. In some embodiments, any material can be used which exhibits strong spin-orbit coupling and exhibits Fermi velocity imbalance in two separate branches of the device.

According to some examples the material of the substrate is different from that of the SC or N materials.

One means of carrying out the present invention is in utilizing gate-controlled tuning of superconducting materials. In some embodiments gate-controlled tuning of a material, namely, utilizing a gate to define a "quantum wire". Herein "quantum wire" refers to a structure embedded inside, on top of, or below a substrate, material, layer and/or film whose properties have been modulated by a gate field to exhibit quantum properties, such as superconductivity.

In some embodiments a plurality of quantum wires can be placed in parallel, along with a corresponding gate-electrode, to achieve the SNSNS structure. Gate-defined superconducting region, such as a quantum wire, can be extrapolated to any desired shape and device structure, according to the requirements of a particular device optimized to achieve the required topological superconductivity, in two or three spatial dimensions. Indeed, in some embodiments, a plurality of top, bottom and/or side-gates can be used independently or in any combination, to achieve the desired gate-field and/or gate-profile, and couple said gate to an SC and/or N region.

In one embodiment, the S material of the SNSNS device is incorporated into a layered structure. In one embodiment, SNSNS junctions further comprise at least one or more of any one of the following additional materials: S material, N material, doped material, semiconducting material, dielectric material, oxide, insulating material, metal, 2D electron gas material, TMD, electron conductors and hole conductors or any combination/s thereof. As used herein a "2D electron gas material" refers to a material which comprises an electron gas that is free to move in two dimensions but is tightly confined in the third dimension. In some embodiments, any of the materials described herein can be doped. In some embodiments the SC material can be selected from any material platform which supports large spin-orbit semiconducting quantum wells such as, but not limited to, HgTe, InAs and InSb.

### Topological Superconducting Devices with Periodic Modulations

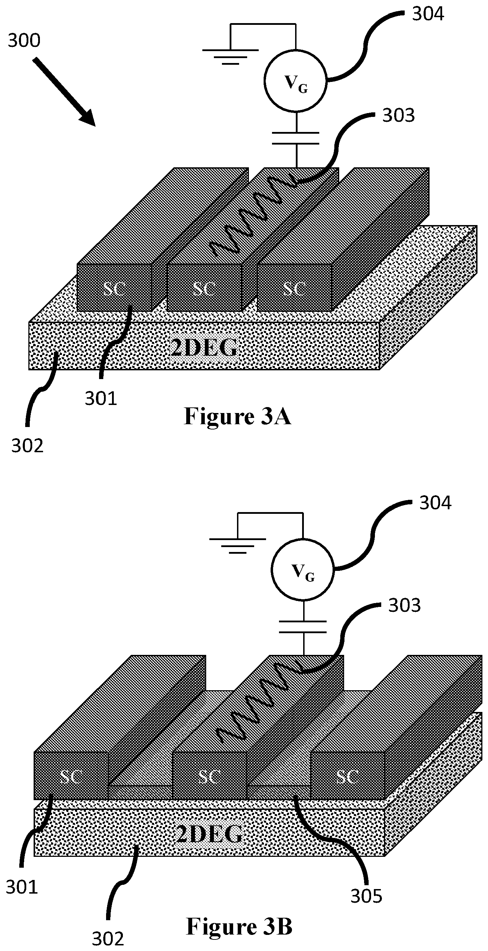

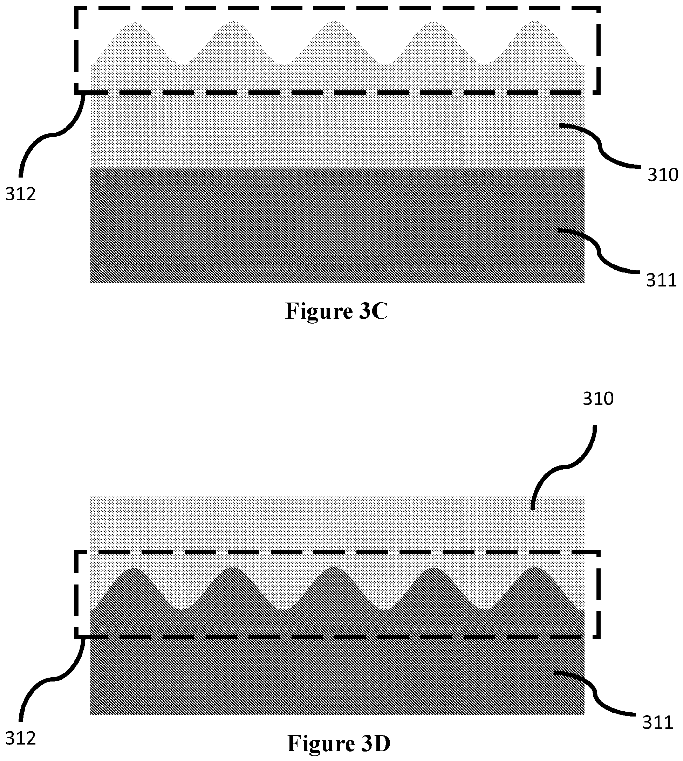

**Figure 3** illustrates ways to induce unequal Fermi velocities, as shown in certain embodiments, combining Rashba SOC with a periodic modulation **303** along the junction i.e., longitudinally, which can induce topological superconductivity. For the purpose of clarity not all coupling layers and structures are shown in **Figure 3****.** As shown in **Figure 3****,** a device **300** with three SC regions **301** which are laterally separated, are disposed on top of a spin-orbit coupled 2D electron gas **302** (i.e., a substrate) wherein the middle superconducting region has a periodic modulation **303,** represented by a sine wave, thereby inducing a topological phase. In some embodiments the SC region **301** is directly in contact with, or in quantum proximity to, the 2DEG **302** and in other embodiments there is at least one layer separating the SC region **301** and the 2DEG **302.** In some embodiments, a periodic modulation **303** induces a modulation to the chemical potential of the middle superconductor. In other embodiments, the periodic modulation **303** induces a modulation in the chemical potential of a superconductor, which isn't the middle one.

In some embodiments, the periodic modulation **303** along the middle SC region is a physical periodic structure along the SC region **301.** Any periodic structural modulation can be utilized such as a sinusoidal wave, square-wave, saw-tooth, zigzag, etc. In some embodiments the periodic modulation is on the surface, under-side or inside, or a combination thereof, of any of the following: the SC regions **301,** the N regions, an intermediate material **305,** the substrate, one of the gate electrodes or any other coupling material or any combination thereof. As used herein "coupling material" refers to any material disposed on top of, underneath, or next to another material and/or layer. In some embodiments the coupling material may be any group selected from: a non-superconducting metal, a 2DEG material, a semiconductor, a dielectric medium, silicon, an oxide or combination thereof. In some embodiments, the periodic modulation **303** is achieved by scratching the surface. In some embodiments the periodic modulation **303** is partly uniform.

**Figure 3C** illustrates a schematic representation of a top layer **310** and a bottom layer **311** in a device. These two layers can represent any of the layered materials in the planar device of the present invention e.g., the SNSNS junction disposed on a substrate. In some embodiments the top layer **310** has a periodic modulation **312** on the top surface in the form of a sinusoid. The region comprising the periodic modulation **312** is indicated by a dotted rectangle. **Figure 3D** illustrates a periodic modulation **312** at the interface or boundary between the top layer **310** and the bottom layer **311.**

In some embodiments the height of the periodic modulation **312** is in the range 1 to 10 nm. In some embodiments the height of the periodic modulation **312** is in the range 1 to 50 nm. In some embodiments the height of the periodic modulation **312** is in the range 1 to 100 nm. In some embodiments the height of the periodic modulation **312** is in the range 50 to 100 nm. In some embodiments the height of the periodic modulation **312** is in the range 100 to 500 nm. In some embodiments the height of the periodic modulation **312** is in the range 500 to 1000 nm. In some embodiments the height of the periodic modulation **312** is in the range 1 to 10 µm. In some embodiments the height of the periodic modulation **312** is in the range 5 to 10 µm. In some embodiments the height of the periodic modulation **312** is greater than 10 µm. As used herein "height" refers to the amplitude of the periodic modulation **312.**

In some embodiments, as shown in **Figure 3A** and **Figure 3B****,** a top gate **304** can be connected to any one of the SC regions **301** and apply a constant or oscillating voltage, appropriately placed and coupled. Said voltage can be applied directly to the corresponding region or indirectly via additional layers and/or electrodes e.g., a plurality of electrodes and dielectric materials. In some embodiments, the applied voltage profile is non-linear, pulsed, periodic and/or non-periodic. In some embodiments, the 2DEG is a substrate **302** upon which the superconducting regions **301** are disposed thereon. In another embodiment the superconducting regions **301** are separated by an intermediate material **305** and/or separated from the substrate, as shown in **Figure 3B****.** In some embodiments the separating intermediate material **305** can be any one of the following: a superconducting material in a non-superconducting state, an insulator, a semiconductor, a 2DEG material and/or an oxide. In further embodiments, the superconducting regions **301** are quantum wires defined by gate-electrodes. In some embodiments, the devices of **Figure 3A** and **Figure 3B** can incorporate more than one gate.

### Phase Winding and Unequal Fermi Velocities

In one-dimensional superconducting systems where time reversal symmetry is broken and translational invariance holds, a transition between trivial and topological phases occurs when there is a single gap closing at zero longitudinal momentum (*kₓ =* 0). For such a single gap closing to occur, spin symmetry must be broken. In many models, the relevant parameter space is two dimensional, with one parameter-the Zeeman energy-breaking the symmetry of the two spin branches. The second parameter is the phase difference for planar Josephson junctions. The application of the Zeeman field separates between the gap closing curves of the two spin branches in the parameter space, thereby separating trivial and topological regions.

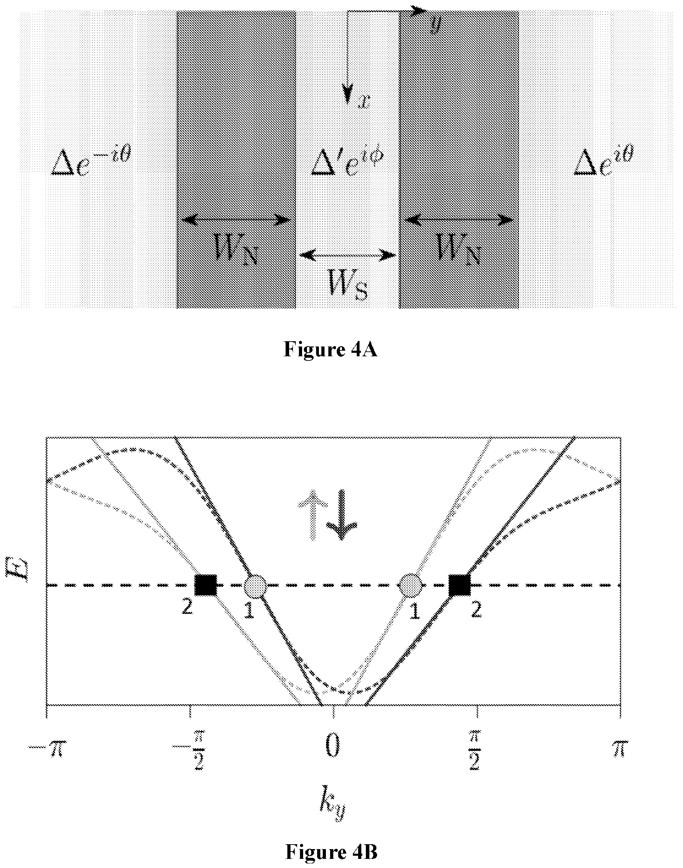

**Figure 4** shows a phase-biased SNSNS junction (superconducting regions are light grey, normal regions are dark grey). An SNS junction between two superconductors have order parameters Δ*e*^{±}*^{iθ}.* If the superconducting gap Δ is much smaller than the Fermi energy *E*_{F}, then at *θ* = π/2, where the phase difference across the junction is π, a double gap closing occurs at the junction, with four states at zero energy. A third superconductor is introduced in the middle of the junction with an order parameter of Δ^{'}*e^{iϕ}*, see **Figure 4A****,** wherein regions between single gap-closing curves in *θ-ϕ* space correspond to a topological phase.

The two outer superconductors are semi-infinite in the transverse direction, *y*, and their superconducting order parameter, Δ, is, in general, different from the middle superconductor, Δ'. At *kₓ* = *0* this reduces to a one-dimensional problem, whose zero energy crossings correspond to topological phase transitions. In **Figure 4B** a transverse spectrum of the junction (dashed lines), in a model including next-nearest neighbor hopping. At the Fermi energy (central dashed black line in **Figure 4B****),** there are four Fermi points (represented as two circles, labelled '1', and two squares, labelled '2'). The Fermi velocities at the "outer" branch (two black squares at *k_{y}=*±π/*2*) and in the "inner" branch (two grey circles closer to *k_{y}*=*0*) are not identical. Solid lines correspond to the linearized spectra.

Materials can be characterized in terms of their band structure and in many cases next-nearest neighbor interactions can be utilized to obtain an empirically observed band structure. Such a band structure can then be used to determine whether a material is suitable for implementation as a component in a topological superconducting device. Materials can thus be selected which exhibit the desired topological superconducting state e.g., one with the largest topological region. For example, 2DEGs of different thicknesses can exhibit a different number of bands and sub-bands which can be selected for to optimize topological superconducting characteristics.

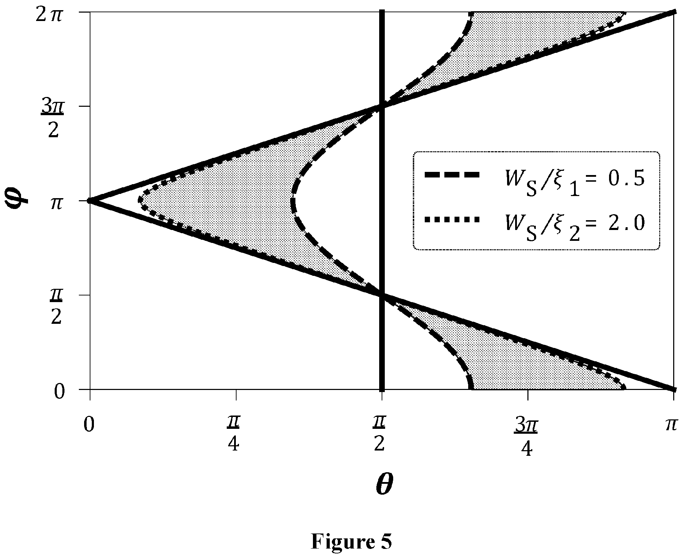

When two spin branches have different velocities, the Zeeman field may be replaced by a second phase difference. In the presence of spin-orbit coupling the Fermi velocities *v*₁, *v*₂ are, in general, not equal. The position of the gap-closing transition within the *θ* - *ϕ* plane is determined by the dimensionless ratio *W_{S}*/*ξⱼ,* where *ξⱼ = vⱼ*/Δ' is the coherence length of the middle superconductor for branch *j* and where *W*_{S} is the width of the middle superconductor. When the middle superconductor is absent (*W_{S} =* 0), the transition occurs for both spins at *θ* = π/2, giving a phase difference of *π.* When the middle superconductor is very wide, the system may be seen as two disconnected junctions, and a gap closing takes place when the phase difference across *one* junction is *π*. In between, the position of the gap closing creates a curve in the *θ-ϕ* plane. In an SNSNS junction, when the velocities in the middle superconductor are unequal, the gap-closing curves for the two spin branches are different. The area between these curves defines the topological region, as illustrated in **Figure 5**. A large topological region (represented by the shaded grey area in between the two non-linear curves) results from very different Fermi velocities for the two branches. The extreme limits are *ξⱼ* = *0*, which corresponds to *θ* = *π*/2, and *ξⱼ* → ∞, corresponding to *ϕ* = *π* ± *θ*.

**Figure 5** shows a phase diagram for the SNSNS geometry of **Figure 4****.** The two values of ξⱼ = vⱼ/Δ' originate from the unequal transverse Fermi velocities. The wide-dotted-line curve and the short-dotted curve correspond to zero-energy crossings at *kₓ* = *0* for *W_{S}*/*ξ₁* = *0.5* and *W_{S}*/*ξ₂* = 2, respectively. Since each of these crossings is nondegenerate, it corresponds to a topological phase transition, and therefore the area between the two curves (shaded area) harbors a topological superconducting state. The solid black lines define the region where a vortex is present.

There are several material platforms where the band structure has such an imbalance wherein the Fermi velocities for the two spin branches are unequal. In some embodiments, the present invention supports any material that exhibits unequal Fermi velocities in an SNSNS configuration, such as TMDs. In some embodiments, a single-material system can be utilized by intrinsic gate-controlled superconductivity and unequal Fermi velocities in layers of TMDs without the need to proximity couple with an external superconductor.

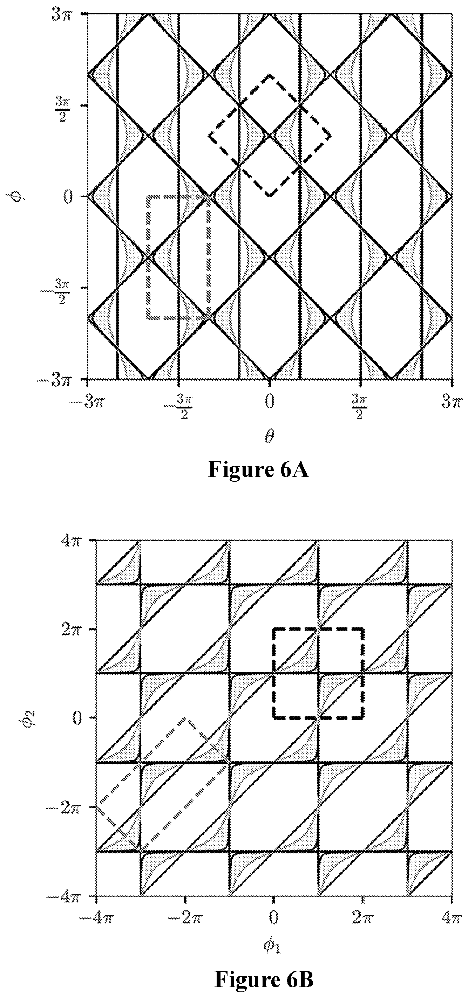

**Figure 6** shows the inherent periodicity of the phases, distinguishing the topological effects from the trivial ones, as mapped out in the phase diagram. **Figures 6A** and **6B** show that the periodic pattern appearing is unique to the phase-induced setup. The dashed black squares denote unit cells, and the dashed gray rectangles show the section of the phase diagram shown in **Figure 5****.**

It will be appreciated that the examples described above, as embodied in various figures, are by way of example, and a device may be provided according to the presently disclosed subject matter or any other configuration that achieves the stated goals of the invention. Furthermore, the presently disclosed examples and embodiments serve to provide a platform wherein the phase difference of the materials in the devices can be controlled, selected and/or tuned in order to provide the required parameters such as phase winding and an unequal Fermi velocity of the materials in the device.

As such, those skilled in the art to which this invention pertains will readily appreciate that numerous changes, variations, and modifications can be made without departing from the scope of the invention as defined by the claims.

## Claims

1. A topological superconducting device comprising:
three adjacent superconducting regions (203), comprising at least one material, disposed on a substrate (201), giving rise to two spin branches;
wherein the said three adjacent superconducting regions exhibit phase winding; and
wherein one spin branch has a Fermi velocity that is not the same as the Fermi velocity of the second spin branch.

2. The topological superconducting device of claim 1 further comprising at least one gate (204), wherein the at least one gate comprises a top-gate, back-gate, side-gate, or combination thereof.

3. The topological superconducting device of claim 1 further comprising two non-superconducting regions (202) disposed between said three adjacent superconducting regions (203), arranged as two SNS junctions with one overlapping superconducting region forming an SNSNS junction and wherein said two SNS junctions comprise at least one material wherein said at least one gate is configured to modulate superconductivity in said at least one material.

4. The topological superconducting device of claim 1 wherein the said three adjacent superconducting regions are arranged in parallel to one another and/or in a planar configuration.

5. The topological superconducting device of claim 1 wherein said substrate is selected from a non-superconducting metal, a 2D electron gas material, a semiconductor, a dielectric medium, silicon, an oxide, or a combination thereof.

6. The topological superconducting device of claim 2 wherein said at least one gate is configured to modulate phase differences between said three adjacent superconducting regions.

7. The topological superconducting device of claim 2 wherein said three adjacent superconducting regions are gate-defined wires.

8. The topological superconducting device of claim 1 wherein the middle superconducting region of said three adjacent superconducting regions is wider than the width of the outer superconducting regions.

9. The topological superconducting device of claim 1 wherein said at least one material is selected from a transition metal dichalcogenide (TMD), Al, Nb, Pb, NbSe₂, HgTe, InAs and InSb, wherein said TMD is TaS₂, MoS₂, MoSe₂, MoTe₂, WS₂, WSe₂, WTe₂, or a combination thereof.

10. The topological superconducting device of claim 1 wherein said at least one material is doped, or wherein said phase winding occurs at multiples of 2π, or a combination thereof.

11. The topological superconducting device of claim 3 further comprising a periodic modulation (312) on top of, underneath and/or inside at least one of said three adjacent superconducting regions;
or further comprising at least one additional superconducting region parallel to said three adjacent superconducting regions;
or a combination thereof.

12. The topological superconducting device of claim 11 further comprising at least one additional non-superconducting region between said at least one additional superconducting region parallel to said three adjacent superconducting regions;
or further comprising additional layers in-between, next to, on top of and/or underneath said least three superconducting regions;
or a combination thereof.

13. A quantum computer comprising the device of claim 1.

14. A topological superconducting array device comprising a plurality of the device according to claim 1.

15. A quantum computer comprising the array device of claim 14.

## Patentansprüche

1. Topologische supraleitende Vorrichtung, umfassend:
drei benachbarte supraleitende Bereiche (203), umfassend mindestens ein Material, das auf einem Substrat (201) angeordnet ist und zwei Spin-Zweige erzeugt;
wobei die drei benachbarten supraleitenden Bereiche eine Phasenwindung aufweisen; und
wobei ein Spin-Zweig eine Fermigeschwindigkeit hat, die nicht mit der Fermigeschwindigkeit des zweiten Spin-Zweigs identisch ist.

2. Topologische supraleitende Vorrichtung nach Anspruch 1, die ferner mindestens ein Gate (204) umfasst, wobei das mindestens eine Gate ein Top-Gate, ein Back-Gate, ein Side-Gate oder eine Kombination davon umfasst.

3. Topologische supraleitende Vorrichtung nach Anspruch 1, die ferner zwei nicht supraleitende Bereiche (202) umfasst, die zwischen den drei benachbarten supraleitenden Bereichen (203) angeordnet sind, die als zwei SNS-Übergänge mit einem überlappenden supraleitenden Bereich angeordnet sind, der einen SNSNS-Übergang bildet, und wobei die beiden SNS-Übergänge mindestens ein Material umfassen, wobei das mindestens eine Gate so konfiguriert ist, dass es die Supraleitung in dem mindestens einen Material moduliert.

4. Topologische supraleitende Vorrichtung nach Anspruch 1, wobei die drei benachbarten supraleitenden Bereiche parallel zueinander und/oder in einer planaren Konfiguration angeordnet sind.

5. Topologische supraleitende Vorrichtung nach Anspruch 1, wobei das Substrat ausgewählt ist aus einem nicht supraleitenden Metall, einem 2D-Elektronengasmaterial, einem Halbleiter, einem dielektrischen Medium, Silizium, einem Oxid oder einer Kombination davon.

6. Topologische supraleitende Vorrichtung nach Anspruch 2, wobei das mindestens eine Gate so konfiguriert ist, dass es Phasendifferenzen zwischen den drei benachbarten supraleitenden Bereichen moduliert.

7. Topologische supraleitende Vorrichtung nach Anspruch 2, wobei die drei benachbarten supraleitenden Bereiche durch Gates definierte Drähte sind.

8. Topologische supraleitende Vorrichtung nach Anspruch 1, wobei der mittlere supraleitende Bereich der drei benachbarten supraleitenden Bereiche breiter ist als die Breite der äußeren supraleitenden Bereiche.

9. Topologische supraleitende Vorrichtung nach Anspruch 1, wobei das mindestens eine Material aus einem Übergangsmetall-Dichalkogenid (TMD), Al, Nb, Pb, NbSe₂, HgTe, InAs und InSb ausgewählt ist, wobei das TMD TaS₂, MoS₂, MoSe2, MoTe₂, WS₂, WSe₂, WTe₂ oder eine Kombination davon ist.

10. Topologische supraleitende Vorrichtung nach Anspruch 1, wobei das mindestens eine Material dotiert ist oder wobei die Phasenwicklung bei Vielfachen von 2π auftritt oder eine Kombination davon.

11. Topologische supraleitende Vorrichtung nach Anspruch 3, ferner umfassend eine periodische Modulation (312) auf, unter und/oder innerhalb mindestens eines der drei benachbarten supraleitenden Bereiche;
oder ferner umfassend mindestens einen zusätzlichen supraleitenden Bereich parallel zu den drei benachbarten supraleitenden Bereichen;
oder eine Kombination davon.

12. Topologische supraleitende Vorrichtung nach Anspruch 11, ferner umfassend mindestens einen zusätzlichen nicht supraleitenden Bereich zwischen dem mindestens einen zusätzlichen supraleitenden Bereich parallel zu den drei benachbarten supraleitenden Bereichen;
oder ferner umfassend zusätzliche Schichten zwischen, neben, auf und/oder unter den mindestens drei supraleitenden Bereichen; oder eine Kombination davon.

13. Quantencomputer, der die Vorrichtung nach Anspruch 1 umfasst.

14. Topologische supraleitende Array-Vorrichtung, umfassend eine Vielzahl der Vorrichtungen nach Anspruch 1.

15. Quantencomputer, umfassend die Array-Vorrichtung nach Anspruch 14.

## Revendications

1. Dispositif supraconducteur topologique comprenant :
trois régions supraconductrices adjacentes (203), comprenant au moins un matériau disposé sur un substrat (201), donnant naissance à deux branches de spin ;
dans lesquelles lesdites trois régions supraconductrices adjacentes présentent un enroulement de phase ; et
dans lequel une seule branche de spin a une vitesse de Fermi qui n'est pas la même que la vitesse de Fermi de la deuxième branche de spin.

2. Dispositif supraconducteur topologique de la revendication 1, comprenant en outre au moins une grille (204),
dans laquelle l'au moins une grille comprend une grille supérieure, une grille arrière, une grille latérale, ou une combinaison de celles-ci.

3. Dispositif supraconducteur topologique de la revendication 1, comprenant en outre deux régions non supraconductrices (202) disposées entre lesdites trois régions supraconductrices adjacentes (203) agencées en deux jonctions SNS avec une région supraconductrice en chevauchement formant une jonction SNSNS, et dans lesquelles lesdites deux jonctions SNS comprennent au moins un matériau dans lequel ladite au moins une grille est configurée pour moduler la supraconductivité dans ledit au moins un matériau.

4. Dispositif supraconducteur topologique de la revendication 1, dans lequel lesdites trois régions supraconductrices adjacentes sont agencées en parallèle les unes aux autres et/ou dans une configuration plane.

5. Dispositif supraconducteur topologique de la revendication 1, dans lequel ledit substrat est choisi parmi un métal non supraconducteur, un matériau à gaz d'électrons 2D, un semiconducteur, un milieu diélectrique, du silicium, un oxyde, ou une combinaison de ceux-ci.

6. Dispositif supraconducteur topologique de la revendication 2, dans lequel ladite au moins une grille est configurée pour moduler les différences de phase entre lesdites trois régions supraconductrices adjacentes.

7. Dispositif supraconducteur topologique de la revendication 2, dans lequel lesdites trois régions supraconductrices adjacentes sont des fils définis par grille.

8. Dispositif supraconducteur topologique de la revendication 1, dans lequel la région supraconductrice centrale desdites trois régions supraconductrices adjacentes est plus large que la largeur des régions supraconductrices extérieures.

9. Dispositif supraconducteur topologique de la revendication 1, dans lequel ledit au moins un matériau est choisi parmi un dichalcogénure de métal de transition (TMD), AI, Nb, Pb, NbSe₂, HgTe, InAs et InSb, dans lequel ledit TMD est TaS₂, MoS₂, MoSe₂, MoTe₂, WS₂, WSe₂, WTe₂, ou une combinaison de ceux-ci.

10. Dispositif supraconducteur topologique de la revendication 1, dans lequel ledit au moins un matériau est dopé, ou dans lequel ledit enroulement de phase se produit à des multiples de 2π, ou une combinaison de ceux-ci.

11. Dispositif supraconducteur topologique de la revendication 3, comprenant en outre une modulation périodique (312) sur le dessus, en dessous et/ou à l'intérieur d'au moins une desdites trois régions supraconductrices adjacentes ;
ou comprenant en outre au moins une région supraconductrice supplémentaire parallèle auxdites trois régions supraconductrices adjacentes ;
ou une combinaison de celles-ci.

12. Dispositif supraconducteur topologique de la revendication 11, comprenant en outre au moins une région non supraconductrice supplémentaire entre ladite au moins une région supraconductrice supplémentaire parallèle auxdites trois régions supraconductrices adjacentes ;
ou comprenant en outre des couches supplémentaires entre, à côté, au-dessus et/ou en dessous desdites au moins trois régions supraconductrices ;
ou une combinaison de celles-ci.

13. Ordinateur quantique comprenant le dispositif de la revendication 1.

14. Dispositif à réseau supraconducteur topologique comprenant une pluralité du dispositif selon la revendication 1.

15. Ordinateur quantique comprenant le dispositif à réseau de la revendication 14.
